# EUROPEAN PATENT APPLICATION

(11) **EP 4 841 678 A1**
(43) Date of publication of application: **18.11.2026**
(21) Application number: 25176471.8
(22) Date of filing: 14.05.2025
(51) Int. Cl.: H01L 25/07

(54) **POWER SEMICONDUCTOR MODULE AND ASSEMBLY METHOD**

(71) Applicant: Hitachi Energy Ltd, 8050 Zürich (CH)
(72) Inventor: Siroky, Georg, 4600 Olten (CH); Roesch, Andreas, 79730 Murg (DE); Truessel, Dominik, 5620 Bremgarten (CH); Santolaria, Lluis, 4600 Olten (CH); Guillon, David, 8857 Vorderthal (CH)
(74) Representative: Michalski Hüttermann & Partner mbB

(57) **Abstract**

The invention relates to a power semiconductor module (1) and a method to assembly the module. The power semiconductor module (1) comprises an electrically conducting base plate (110), a plurality of power semiconductor devices (100) arranged on the base plate (110) with top contact surfaces (101) facing away from the base plate (110), a plurality of metal preforms (130) arranged on the top contact surfaces (101), and a distribution plate (140) electrically connecting the top contact surfaces (101) in parallel via the plurality of metal preforms (130), wherein the distribution plate (140) comprises a flat plate structure (141) and multiple protruding contact portions (142) extending toward and abutting the plurality of metal preforms (130). This combination of metal preforms (130) and distribution plate (140) may facilitate the compensation of mechanical tolerance and thermal expansion for the power semiconductor module (1)

## Description

### Technical Field

The invention relates to the technical field of power modules, in particular, a power semiconductor module and a method for assembling the power semiconductor module.

### Background Art

Power semiconductor modules are critical components in high-voltage applications like high-voltage direct current, HVDC, systems. These power semiconductor modules, especially power modules with pressure contacts, are typically arranged in a large stack to provide a serial connection of multiple power modules, ensuring efficient power conversion and transmission. Moreover, these modules usually integrate multiple semiconductor devices, such as insulated-gate bipolar transistors, IGBTs, or metal-oxide-semiconductor field-effect transistors, MOSFETs, in a common package, enabling efficient and reliable power switching.

For the modern high-voltage and high-power application utilizing a large stack of modules, it is essential to ensure Short Circuit Failure Mode, SCFM, capability. Specifically, in the event of failure, an affected chip must maintain a low-resistance state to sustain uninterrupted current flow, either for an extended period until scheduled maintenance can be conducted or for at least a few minutes until secondary protection mechanisms, such as a mechanical bypass, are activated. In this scenario, the defective module behaves like a simple conductor, whereas the stack of power modules remains functional. Achieving SCFM capability requires the semiconductor module's ability to withstand higher short-circuit current.

To address the increased SCFM capability requirement, distribution plates have been introduced to interconnect electrical contacts both electrically and thermally in parallel. These distribution plates enable lateral current sharing and heat distribution across multiple chips and terminals, thereby reducing the burden on any single electrical path, especially in SCFM conditions, to carry all current. For instance, some designs propose arranging a rigid distribution plate directly engaging the top surfaces of the multiple electrically parallel chips of the power semiconductor module. This structural arrangement potentially reduces localized heating of the failed chip and of the electrical path during failure conditions.

However, these designs also introduce significant mechanical challenges. Due to manufacturing tolerances such as soldered Die-bond, the semiconductor chips may be slightly tilted or misaligned, causing non-uniform pressure distribution when the flat contact surface of the distribution plate presses against the chip surfaces. This can lead to a reduced effective contact area and excessive localized pressure, risking mechanical damage to the chips. Furthermore, thermal expansion mismatches between different materials of the chip the distribution plate and other components of the semiconductor module, especially in the SCFM conditions, can result in additional lateral stress and mechanical fatigue at the interfaces, leading to compromised reliability under high-current conditions.

There is thus a need for an improved power semiconductor module with capabilities to compensate manufacturing tolerances and thermal expansions while ensuring current and heat distribution under high-current operating conditions, especially the SCFM scenarios.

### Summary of invention

It is therefore an object of the invention to provide a long-term reliable power semiconductor module with enhanced current-carrying capacity and heat dissipation, especially in SCFM conditions, while simultaneously reducing internal mechanical stress across the semiconductor device and a corresponding assembly method to support the high-current requirements of modern high-voltage, high-power applications.

The object of the invention is solved by the independent claims. Preferred implementations are detailed in the dependent claims.

According to a first aspect of the invention, the object is solved by a power semiconductor module comprising
an electrically conducting base plate,
a plurality of power semiconductor devices arranged on the base plate with top contact surfaces facing away from the base plate,
a plurality of metal preforms arranged on the top contact surfaces, and
a distribution plate that electrically connects the top contact surfaces in parallel via the plurality of metal preforms,
wherein the distribution plate comprises a flat plate structure and multiple protruding contact portions extending toward and abutting the plurality of metal preforms.

Here, the metal preform refers to a metal layer, a metal platelet, or a metal electrode formed and/or arranged on the top contact surface of each power semiconductor device. In this context, electrically conducting means that the component is electrically conductive. The distribution plate is electrically conductive. Specifically, the number of the multiple protruding contact portions may equal the number of the power semiconductor devices. The protruding contact portions, the metal preforms, and the power semiconductor devices may be arranged in one-to-one correspondence.

According to this implementation, the multiple protruding contact portions may be electrically and/or thermally interconnected by the flat plate structure. The flat plate structure may facilitate lateral current sharing between the plurality of power semiconductor devices. Especially in SCFM conditions, the heat and current from a failed power semiconductor device may be distributed laterally via the flat plate structure.

A key point of the invention is a combination of the plurality of metal preforms and the distribution plate directly arranged above the metal preforms. On one hand, the metal preforms are arranged as intermediate elements between the top contact surfaces of the plurality of power semiconductor devices and the contact portions of the distribution plate. This may enable compensation of mismatches between the chips and the protruding contact portions of the distribution plate due to different coefficients of thermal expansion and/or mechanical tolerance, such as tilt of the power semiconductor devices, thereby facilitating the even pressure distribution across the power semiconductor devices and improving the long-term durability of the power semiconductor module.

On the other hand, in events of failure, the high temperature of the affected chip and electrical contact may cause the corresponding metal preform to melt, forming a eutectic alloy with the chip material that renders the affected chip conductive as a short circuit while the distribution plate enables a more balanced distribution of the short circuit current and heat, thus enhancing the SCFM capability of the module. It should be noted that whether the corresponding metal preform melts and/or forms a eutectic alloy with the chip material depends on the choice of the material forming the metal preform.

According to an implementation of the present invention, the power semiconductor module may further comprise an electrically conducting top plate arranged in parallel to the base plate with a bottom surface facing the distribution plate, and at least one spring, at least one pressure element, and/or at least one presspin contact arranged between the bottom surface of the top plate and the distribution plate.

In this implementation, at least one spring, at least one pressure element, or at least one presspin contact may be arranged between the top plate and the distribution plate as a buffer and may provide mechanical pressure on the distribution plate. In this context, the term 'pressure element' refers to an element that can deform elastically to provide a pressing force.

Specifically, the elastic deformation of the spring or the pressure element may produce mechanical forces pressing the distribution plate toward the metal preforms. This may ensure a stable connection between the protruding contact portions and the metal preforms, and consequently a stable electrical connection to the plurality of power semiconductor devices. In addition, the usage of the spring and/or the pressure element may compensate for height tolerances between different power semiconductor modules with reduced design complexity.

Optionally, the at least one spring, the at least one pressure element and/or the at least one presspin contact may be electrically conductive. The at least one spring, the at least one pressure element and/or the at least one presspin contact may establish an electrical connection between the top plate and the distribution plate, thereby establishing an electrical connection between the plurality of power semiconductor devices and the top plate.

According to one implementation of the present invention, the at least one spring may comprise at least one of the following: a spiral spring, a spring consisting of multiple disk-shaped elements, a volute spring, and a wave spring. It should be noted that the configuration of the spring is not limited to these examples. The at least one spring may be any kind of spring suitable for use in the power semiconductor module, provided the dimension and mechanical requirements associated with the operation of the module are fulfilled.

Optionally, when at least one spring is arranged between the top plate and the distribution plate, the power semiconductor module may further comprise at least one current-carrying bracket surrounding and/or located beside the at least one spring.

The current-carrying bracket may be electrically conductive and may establish a current path between the distribution plate and the top plate. When the current-carrying bracket is used, the spring may be electrically conductive or non-electrically conductive. In addition, the number of the current-carrying bracket and the springs can be the same or different.

Alternatively, the at least one pressure element may comprise at least one of the following: skived fins, a copper foam, a honeycomb structure, and a cushion element. Similarly, the configuration and shape of the pressure element are not limited to these examples. Any pressure element that can deform elastically and provide pressing force may be used, provided the dimensional requirements and mechanical requirements of the module are fulfilled.

According to an implementation of the present invention, the flat plate structure and the multiple protruding contact portions may be formed as integral pieces or as separate parts. Specifically, the flat plate structure and the multiple protruding contact portions may be formed integrally as a single monolithic piece to further improve mechanical stability.

Alternatively, the multiple protruding contact portions may be manufactured as independent components and subsequently joined to the flat plate structure. For example, the independent protruding contact portions may be connected to predefined locations of the flat plate structure via welding, soldering, mechanical fastening, such as screws, bolts, adhesive bonding, or any other applicable approaches. The predefined locations may be aligned to the positions of the power semiconductor devices. In this case, it is possible to flexibly adapt the number and layout of the protruding contact portions according to the number, size, and layout of the plurality of power semiconductor devices. Especially when different types of power semiconductor devices are used in parallel, a flexible configuration and layout of multiple protruding contact portions with different sizes can be achieved.

According to an implementation of the present invention, the multiple protruding contact portions may have flat bottom contact surfaces abutting the plurality of metal preforms. This may further improve the current and heat distribution capacity of the distribution plate.

Optionally, the multiple protruding contact portions may have a round, oval, square, or rectangular cross-sectional shape. It should be noted that the cross-sectional shape of the protruding contact portions is not limited to these examples; different shapes may be used according to practical requirements.

As an option, each protruding contact portion may have a diameter or horizontal extension between 5 mm and 20 mm. Here, the horizontal extension refers to a width or a length of the cross-section of the protruding contact portion. Preferably, the diameter or the horizontal extension of each protruding contact portion may range from 10 mm to 15 mm. Optionally, each protruding contact portion may have a vertical extension, i.e., a height between 2 mm and 20 mm; preferably, between 3 mm and 10 mm. The multiple protruding contact portions may have the same height.

Moreover, the flat plate structure may have a vertical extension, namely, a height or thickness between 0.5 mm and 10 mm; preferably, between 0.5 mm and 3 mm. The horizontal extension, namely, the width and the length of the flat plate structure may be defined according to the dimension of the base plate, the size requirement of the power module, and/or the distribution of the power semiconductor devices. The flat plate structure may not extend beyond an outer circumference of the base plate.

It should be noted that the dimensions of the protruding contact portions and the flat plate structure are not limited to these examples and may be determined based on the current and heat distribution requirements, and/or stress distribution requirements of the power semiconductor module.

According to an implementation of the present invention, the flat plate structure and/or the multiple protruding contact portions may be made of a material with high electrical and thermal conductivities. For example, the material may comprise copper, copper alloys, aluminium, aluminium alloys, and/or other materials with similar or better electrical and thermal conductivities. In addition, the material may have a melting point higher than the maximum temperature of the power semiconductor in the event of short-circuit failures. The protruding contact portions may be made of a material identical to or different from the flat plate structure.

According to an implementation of the present invention, the plurality of metal preforms may be connected to the top contact surfaces via soldering, sintering, adhesive bonding, or other applicable approaches.

Optionally, the plurality of metal preforms may be made of a material comprising at least one of the following: molybdenum, molybdenum alloys, aluminium, and aluminium alloys. It is noted that the material of the metal preforms is not limited to these examples. Other electrically conductive materials can also be used, provided that the requirements of electrical conductivity and melting point for the power semiconductor module are fulfilled.

According to a preferred implementation of the present invention, the multiple protruding contact portions are mechanically connected to the plurality of metal preforms simply by pressing. As discussed above, the spring or the pressure element may provide the mechanical force pressing the distribution plate toward the metal preforms. In this case, the protruding contact portions are connected to the metal preforms simply via surface-contact connection without additional joining members or elements.

Alternatively, the multiple protruding contact portions may be connected to the plurality of metal preforms via soldering, sintering, adhesive bonding or other applicable approaches to further enhance mechanical stability.

As an option, each metal preform may have a diameter or horizontal extension between 5 mm and 20 mm, preferably between 8 mm and 15 mm, more preferably, between 8 mm and 13 mm. Here the horizontal extension also refers to a width or a length of the metal preform. Optionally, each metal preform may have a vertical extension, i.e., a height, between 0.2 mm and 3 mm; preferably, between 0.5 mm and 2 mm. It should be noted that the dimension of the metal preform is not limited to these examples and may be determined based on practical needs.

Another aspect of the invention further provides a method for assembling the power semiconductor module according to any one of the previous claims, comprising the steps of:
attaching a plurality of power semiconductor devices to an electrically conducting base plate,
connecting a plurality of metal preforms to top contact surfaces of the plurality of power semiconductor devices, and
aligning and attaching a distribution plate to the plurality of metal preforms.

The semiconductor chips can be attached to the base plate via soldering, sintering or other similar approaches.

Optionally, the method may further comprise the steps of mounting at least one spring, at least one pressure element, and/or at least one presspin contact to a bottom surface of an electrically conducting top plate and pressing the top plate with the at least one spring, at least one pressure element, and/or at least one presspin contact to the distribution plate.

Alternatively, the method may further comprise the step of arranging the at least one spring, at least one pressure element, and/or at least one pressin contact on the distribution plate and pressing and mounting the electrically conducting top plate with the bottom surface towards the at least one spring, the at least one pressure element, and/or the at least one presspin contact.

### Brief description of drawings

These and other aspects of the invention will be apparent from and elucidated with reference to the implementations described hereinafter.

In the drawings:
Fig. 1 shows a side view diagram of an implementation of a power semiconductor module with metal preforms, a distribution plate, and a spring.
Fig. 2 shows a side view diagram of another implementation of the power semiconductor module with the metal preforms, the distribution plate, springs and current-carrying brackets surrounding the springs.
Fig. 3 shows a side view diagram of another implementation of the power semiconductor module with the metal preforms, the distribution plate, a spring, and current-carrying brackets located beside the spring.
Fig. 4 shows a side view diagram of another implementation of the power semiconductor module with the metal preforms, the distribution plate, and a honeycomb structure as the pressure element.
Fig. 5 shows a side view diagram of another implementation of the power semiconductor module with the metal preforms, the distribution plate, and presspin contacts.
Fig. 6 shows an implementation of the distribution plate.
Fig. 7 shows a flow chart according to an implementation of a power semiconductor module assembling method.
Fig. 8 shows a flow chart of additional method steps of the power semiconductor module assembling method shown in Fig.7.
Fig. 9 shows a flow chart of additional method steps of the power semiconductor module assembling method shown in Fig.7.

### Description of implementations

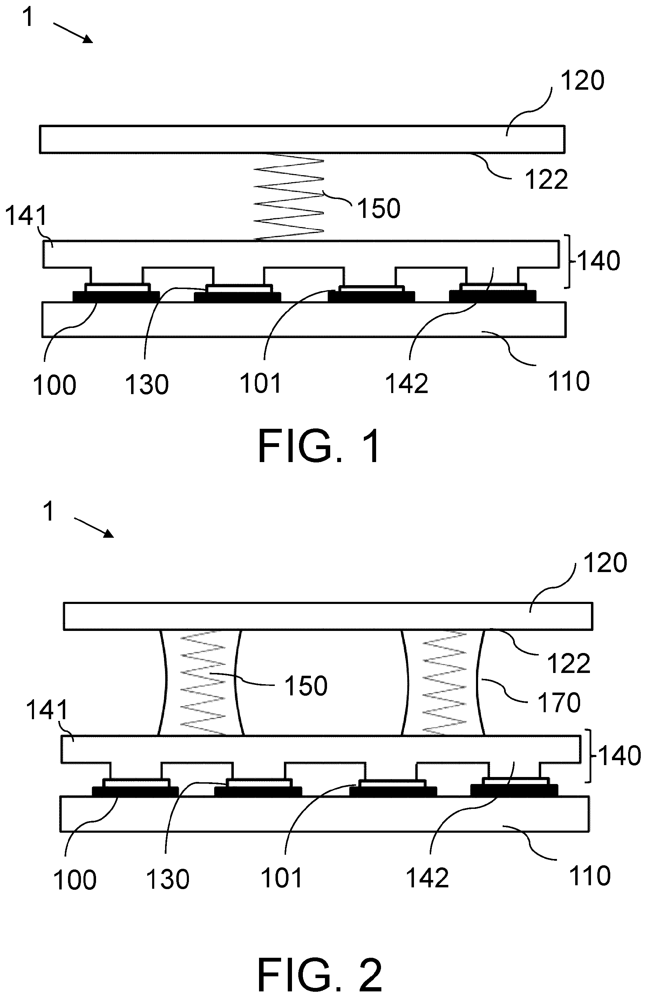

Fig. 1 shows a side view diagram of an implementation of a power semiconductor module 1 with metal preforms 130, a distribution plate 140, and a spring 150.

Here, the power semiconductor module 1 refers to a functional unit of power applications. It can be combined with other power semiconductor modules, capacitors, and /or control circuitry into a single package to handle power conversion, regulation, or switching at a system level. For different definitions, the power semiconductor module may also refer to a semiconductor power submodule, such as a semiconductor switching unit. A plurality of the power semiconductor modules 1 may be electrically connected in parallel to form a larger power module.

As shown in Fig. 1, the power semiconductor module 1 comprises an electrically conducting base plate 110 and an electrically conducting top plate 120 arranged in parallel to each other. A plurality of power semiconductor devices 100 is arranged on the base plate 110 with top contact surfaces 101 facing away from the base plate 110. A plurality of metal preforms 130 is arranged on the top contact surfaces 101.

A distribution plate 140 is arranged above the plurality of metal preforms 130 to electrically interconnect the top contact surfaces 101 of the power semiconductor devices 100 in parallel. It can be seen from Fig. 1 that the distribution plate 140 comprises a flat plate structure 141 and multiple protruding contact portions 142. The multiple protruding contact portions 142 extend from a bottom surface of the flat plate structure 141 and connect directly to the plurality of metal preforms 130.

By positioning the distribution plate 140 directly above the metal preforms 130 and the power semiconductor devices 100, direct current distribution and improved heat dissipation and distribution are provided close to the chip level, which minimizes electrical and thermal resistance, ensuring a more efficient and uniform current flow. Specifically, in the SCFM case, a shorter current and thermal path between the distribution plate 140 and the affected power semiconductor devices 100 can be established. Thus, especially in the SCFM conditions, current and heat from the affected power semiconductor devices 100 may be distributed effectively.

The number of the multiple protruding contact portions 142 may equal the number of the plurality of power semiconductor devices. As shown in Fig. 1, each protruding contact portion 142 may align with one power semiconductor device 100 and electrically connect to its top contact surface 101 via a corresponding metal preform 130.

The top contact surfaces 101 of the plurality of semiconductor devices may be emitter areas, the bottom contact surfaces of the plurality of semiconductor devices 100 may be collector areas, and vice versa. Alternatively, the top contact surfaces 101 of the plurality of semiconductor devices may be source areas, the bottom contact surfaces of the plurality of semiconductor devices 100 may be drain areas, and vice versa.

Although not depicted in Fig. 1, the power semiconductor module 1 may comprise multiple rows and columns of power semiconductor devices 100. The plurality of power semiconductor devices 100 may be arranged in a manner forming a kind of array or 2D arrangement. The number of rows and columns may be determined based on the practical requirements of the power applications. The distribution and the number of the power semiconductor devices 100 may also be determined based on a geometry of the base plate 110.

The power semiconductor devices 100 may be semiconductor chips. The power semiconductor devices 100 may comprise insulated gate bipolar transistors, IGBTs, metal-oxide-semiconductor field-effect transistors, MOSFETs, high electron mobility transistors, HEMTs, and/or diodes made of silicon, silicon carbide, gallium nitride, and/or other similar devices. The power semiconductor devices 100 may be of the same type or different types. For example, the power semiconductor devices 100 may comprise IGBTs and diodes connected in parallel.

As further depicted in Fig. 1, the power semiconductor module 1 may comprise a spring 150 arranged between the top plate 120 and the distribution plate 140. One end of the spring 150 may be connected to a bottom surface 122 of the top plate 120 while another end of the spring 150 may be connected to the flat plate structure 141 of the distribution plate 140.

The spring 150 may produce mechanical forces pressing the distribution plate 140 toward the plurality of metal preforms 130 to ensure a stable connection, especially in case of a dry contact. The spring 150 could additionally serve as a vibration-damping mechanism for the power semiconductor module 1. As an option, the spring 150 may be placed at a geometrical center of the distribution plate to ensure balanced pressure across the power semiconductor devices. In addition, the spring 150 may be electrically conductive and may establish a current path between the distribution plate 140 and the top plate 120.

It should be noted that, although not depicted in Fig. 1, the power semiconductor module 1 may comprise multiple springs distributed evenly or unevenly between the top plate 120 and the distribution plate 140. For example, the number of the springs 150 may equal the number of the protruding contact portions 142. Each spring 150 may be arranged directly above one protruding contact portion 142. Alternatively, the number of the springs 150 may be less or greater than the number of the protruding contact portions. In this case, the springs 150 may be evenly distributed above the distribution plate 140. The number and layout of the springs 150 may be determined based on the practical needs of the power semiconductor module 1.

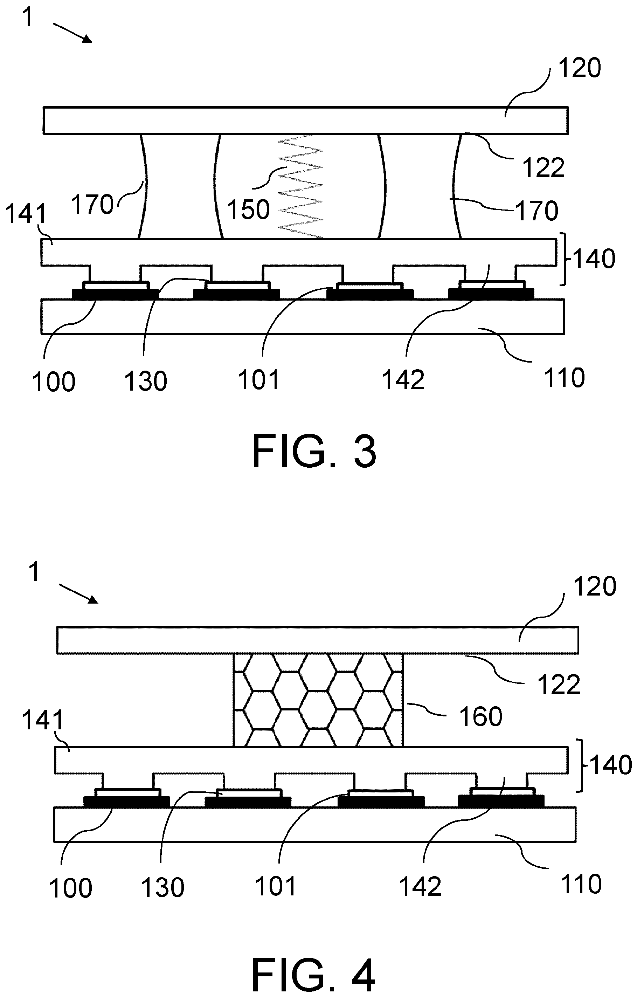

Fig. 2 and Fig. 3 illustrate side view diagrams of other implementations of the power semiconductor module 1 with the metal preforms 130, the distribution plate 140, springs 150, and current-carrying brackets 170. The implementations shown in Fig. 2 and Fig. 3 correspond substantially to the configuration shown in Fig. 1, with the exception that they additionally comprise current-carrying brackets 170 surrounding or located beside the springs 150. Since the remaining components, such as the power semiconductor devices 100, the base plate 110, the top plate 120, the distribution plate 140, the metal preforms 130 and so on, including their structural arrangement and function, can be identical to those described with reference to Fig. 1, repeated description is omitted for the sake of brevity.

As shown in Fig. 2, two springs 150 may be arranged mainly vertically between the top plate 120 and the distribution plate 140. The two springs 150 are surrounded respectively by the current-carrying brackets 170. In this implementation, the current-carrying brackets 170 can be electrically conductive and may establish current paths between the distribution plate 140 and the top plate 120. In this case, the springs 150 may be non-electrically conductive and only serve to provide pressing forces. As an option, the springs 150 may also be electrically conductive.

Each current-carrying bracket 170 may comprise a pair of flexible flat metal sheets. The pair of flexible flat metal sheets may be arranged opposite to each other to form the current-carrying bracket 170. The pair of flexible flat metal sheets may be manufactured as an integral current-carrying bracket 170.

It should be noted that, although not depicted in Fig. 2, the power semiconductor module 1 may comprise only one spring 150, which is surrounded by the current-carrying bracket 170. Alternatively, the power semiconductor module 1 may comprise multiple springs 150 evenly or unevenly distributed across the distribution plate 140. At least one of the multiple springs may be surrounded by the current-carrying bracket 170. That is, the number of the springs 150 and the number of the current-carrying brackets 170 may be equal or different.

The number of the springs 150 and/or the number of the current-carrying brackets 170 may be equal to or different from the number of the protruding contact portions 142. For example, the number of the springs 150 may equal the number of the protruding contact portions 142. Each spring 150 may be arranged directly above one protruding contact portion 142. At least one of the springs 150 may be surrounded by a corresponding current-carrying bracket 170.

Alternatively, as shown in Fig. 3, one spring 150 may be arranged between the top plate 120 and the distribution plate 140, preferably at the geometrical center of the flat plate structure 141. Instead of surrounding the spring 150, two current-carrying brackets 170 are arranged beside the spring 150. The current-carrying brackets 170 may be electrically conductive, and the spring 150 may be electrically conductive or non-conductive. The current-carrying brackets 170 may mainly function to establish current paths between the top plate 120 and the distribution plate 140.

Distances between the spring 150 and the two current-carrying brackets 170 may be the same to facilitate even pressure distribution across the plurality of power semiconductor devices 100. Optionally, distances between the spring 150 and the two current-carrying brackets 170 may also be different. The spring 150 and the current-carrying brackets 170 may be arranged in a row, a column, or along a diagonal direction of the flat plate structure 141. The spring 150 may be arranged with its central axis substantially perpendicular to the flat plate structure 141.

It should be noted that the number of current-carrying brackets 170 and the number of the springs 150 may be varied with respect to the implementation shown in Fig. 3. The number of the current-carrying brackets 170 and the number of the springs 150 may be the same or different. The number of the current-carrying brackets 170 and the number of the springs 150 may be determined based on the current and mechanical requirements of the power semiconductor module 1.

For example, the power semiconductor module 1 may comprise one spring 150 and one current-carrying bracket 170 arranged beside each other between the top plate 120 and the distribution plate 140. Optionally, the power semiconductor module 1 may comprise a single spring 150 and multiple current-carrying brackets 170, which are evenly distributed around the spring 150, preferably in a separate manner, so as to surround it in a circumferential or symmetric manner. In another specific example, the power semiconductor module 1 may comprise multiple springs 150 and multiple current-carrying brackets 170. The multiple springs 150 and/or the multiple current-carrying brackets 170 may be evenly or unevenly distributed across the flat plate structure 141. In certain configurations, the multiple springs 150 and the multiple current-carrying brackets 170 may also be arranged in an interlaced or alternating manner to achieve a balanced mechanical and electrical layout.

Although not explicitly depicted in FIGS. 1 to 3, it should be noted that the implementations shown therein may be combined. In certain configurations, the power semiconductor module 1 may comprise a combination of at least two of the following elements: a spring 150; a spring 150 surrounded by a current-carrying bracket 170; and a current-carrying bracket 170 positioned adjacent to, but not surrounding, the spring 150. The combination and layout of these elements may be determined based on practical needs.

For the implementations shown in Fig.1 to Fig. 3, the spring 150 can be a spiral spring, a spring consisting of multiple disk-shaped elements, a volute spring, a wave spring, a conical spring, a leaf spring or any other suitable type of spring capable of providing elastic force and mechanical compliance. When multiple springs 150 are applied, the multiple springs 150 may be the same or different. The choice and layout of the springs 150 may be determined based on practical needs.

According to some implementations of the present invention, a pressure element 160 may be used instead of or in combination with the springs 150 detailed above. In some configurations, the power semiconductor module 1 may comprise at least one pressure element 160 arranged between the top plate 120 and the distribution plate 140. The pressure element may function like the spring 150 to provide mechanical force pressing the distribution plate 140 toward the metal preforms 130 and may additionally serve as a vibration-damping mechanism. In this implementation, the pressure element 160 is electrically conductive to establish current paths between the top plate 120 and the distribution plate 140.

Fig. 4 illustrates a side view diagram of other implementations of the power semiconductor module 1 with the metal preforms 130, the distribution plate 140, and the pressure element 160. The implementations shown in Fig. 4 correspond substantially to the configuration shown in Fig. 1, with the exception that they comprise pressure elements 160 instead of the springs 150. Since the remaining components, including their structural arrangement and function, can be identical to those described with reference to Fig. 1, repeated description is omitted for the sake of brevity.

Fig. 4 shows an alternative implementation of the present invention using a honeycomb structure as the pressure element 160. As depicted in Fig. 4, one honeycomb structure may be arranged at the geometrical center of the flat plate structure 141. The honeycomb structure may comprise multiple hexagonal cells aligned side-by-side. In this case, the honeycomb structure may be oriented such that the central axes of the hexagonal cells extend in a direction parallel to the top plate 120.In other words, the honeycomb structure may be oriented such that it can work like a spring.

The honeycomb structure may be made of an electrically conductive material so as to establish current paths between the top plate 120 and the distribution plate. The size and dimensions of the honeycomb structure may be determined based on practical needs. The honeycomb structure may also be made of an insulation material. In this implementation, the honeycomb structure may work cooperatively with the current-carrying brackets 170 or other conducting elements positioned beside it.

Alternatively, the power semiconductor module 1 may comprise multiple honeycomb structures distributed evenly or unevenly across the distribution plate 140. The number of honeycomb structures may be equal to or different from the number of the multiple protruding contact portions 142. Specifically, the number and distribution of the honeycomb structures may be varied for applications with different requirements. In some configurations, the number of the honeycomb structures may equal the number of the multiple protruding contact portions 142. Each honeycomb structure may align with one of the multiple protruding contact portions 142.

It should be noted that, apart from the honeycomb structure, the pressure element 160 may be implemented as: skived fins, a copper foam, a honeycomb structure, a cushion element, or other kinds of elements that can provide pressing forces. When multiple pressure elements 160 are applied, the multiple pressure elements 160 may be the same or different. The choice and layout of the pressure elements 160 may be determined based on practical needs.

In some configurations, the pressure element 160 may be used in combination with the spring 150. For example, the power semiconductor module 1 may comprise a pressure element 160 arranged at the geometrical center of the distribution plate 140 and multiple springs 150 evenly distributed around the pressure element 160 so as to surround it in a circumferential or symmetric manner, or vice versa. The choice and layout of the pressure elements 160 and springs 150 may be determined based on practical needs. The pressure elements 160 and/or the springs 150 may be made of an electrically conductive material. The pressure elements 160 and the springs 150 may be made of an insulation material and may work cooperatively with the current-carrying brackets 170 or other conducting elements positioned beside them.

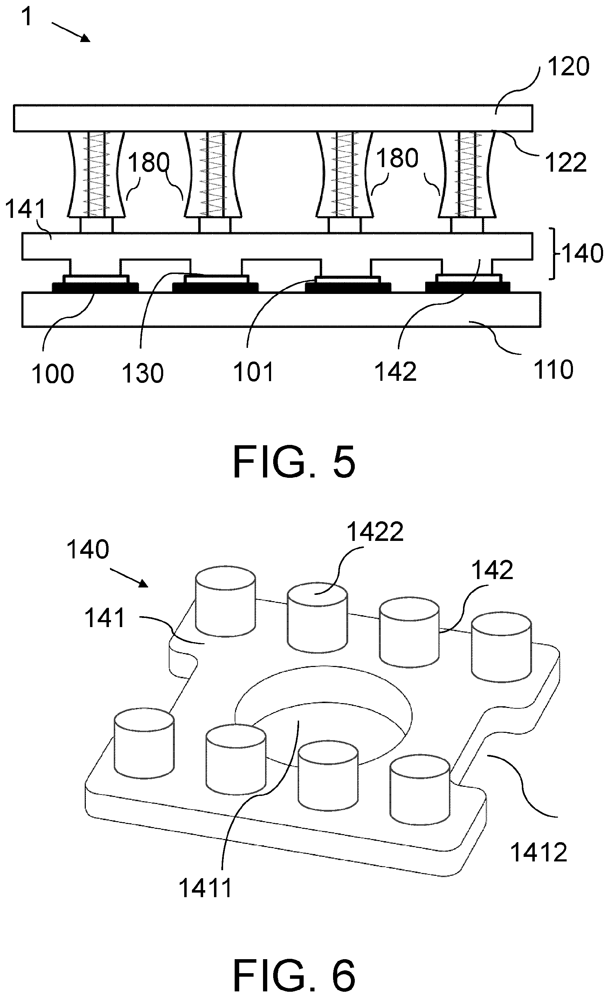

Fig. 5 illustrates side view diagrams of other implementations of the power semiconductor module 1 with the metal preforms 130, the distribution plate 140, and presspin contacts 180. The implementations shown in Fig. 5 correspond substantially to the configuration shown in Fig. 1, with the exception that they comprise presspin contacts 180 instead of the springs 150. Since the remaining components, including their structural arrangement and function, can be identical to those described with reference to Fig. 1, repeated description is omitted for the sake of brevity.

As depicted in Fig. 5, a plurality of presspin contacts 180 may be arranged between the top plate 120 and the distribution plate 140. Each presspin contact 180 may align with one protruding contact portion 142. This may facilitate a balanced pressure distribution by providing pressure directly on the multiple protruding portions 142.

As further illustrated in Fig. 5, each presspin contact 180 may comprise a presspin body, a spring, and a current-carrying bracket. The presspin body may comprise a pin foot and a pin above the pin foot. The pin and pin foot may be formed as a single piece or be fixed together in a flexible manner. The pin foot may have a width, a length or a diameter greater than the pin.

The spring and the current-carrying bracket may be sleeved on the presspin body, preferably, on the pin of the presspin body, with the current-carrying bracket surrounding the spring and/or the presspin body, especially the pin of the presspin body. It should be noted that other structures of the presspin contacts 180 suitable for applications in power semiconductor modules can also be applied.

The number of the presspin contacts 180 may also be the same or different from the number of the protruding contact portions 142. In some configurations, the presspin contacts 180 may not be aligned with the protruding contact portions 142 but simply distributed evenly or unevenly across the distribution plate 140.

Fig. 6 shows a structure of the distribution plate 140 that can be used for the power semiconductor modules 1 depicted in Fig. 1 to Fig. 5. For illustrative purposes, the distribution plate 140 shown in Fig. 6 is depicted in an upside-down orientation to better explain its structure and the arrangement of the protruding contact portions 142. As depicted, the distribution plate 140 comprises the flat plate structure 141 and multiple protruding contact portions 142. The multiple protruding contact portions 142 are provided on one surface of the flat plate structure 141. During use, this surface comprising the multiple protruding contact portions 142 is arranged towards the plurality of metal preforms 130.

The multiple protruding contact portions 142 may be formed as an integral part of the flat plate structure 141. Alternatively, the multiple protruding contact portions 142 may be formed independently and fixed to the flat plate structure 141. The protruding contact portions 142 and the flat plate structure 141 may be fixed by welding, soldering, screws, bolts, adhesive bonding, or any other applicable approaches. By providing the flat plate structure 141 and the multiple protruding contact portions 142 as separate parts, it is possible to change the layout and number of the protruding contact portions flexibly according to the number, size, and layout of the plurality of power semiconductor devices 100. Especially when different types of power semiconductor devices 100, such as IGBTs and diodes, are used in parallel, a flexible configuration and layout of multiple protruding contact portions 142 with different sizes can be achieved.

As illustrated in Fig. 6, the multiple protruding contact portions 142 may have flat bottom contact surfaces 1422. During use, the bottom contact surfaces 1422 may be placed in direct contact with the plurality of metal preforms 130. It should be noted that, although the protruding contact portions 142 in Fig. 6 comprise a round cross-sectional shape, different geometries can also be used. For example, the multiple protruding contact portions 142 may have round, oval, square, or rectangular cross-sectional shapes for their bottom contact surfaces 1422. In addition, the protruding contact portions 142 may have a three-dimensional shape such as a cylinder, a truncated cone, a rectangular prism, a cube, or any other suitable geometry that facilitates reliable electrical and mechanical contact with the underlying metal preforms 130.It should be noted that the shapes of the multiple protruding contact portions 142 are not limited to the above-mentioned examples.

The protruding contact portions, preferably, the bottom contact surfaces 1422 of the protruding contact portions 142, may have a diameter or horizontal extension up to 20 mm. For example, 2mm, 4mm, 5 mm, 7 mm, 9 mm, 12 mm, 13 mm, or 16 mm. Here the horizontal extension refers to a width or a length of the cross-section of the protruding contact portion. Preferably, the diameter or the horizontal extension of each protruding contact portion may range from 10 mm to 15 mm. In addition, each protruding contact portion may have a vertical extension, i.e., a height between 2 mm and 20 mm; preferably, between 3 mm and 10 mm; for example, 5 mm, 8 mm, 10 mm, 12 mm, or 16 mm. The multiple protruding contact portions may have the same height.

Further, the flat plate structure 141 may simply be a solid metal plate, or as shown in Fig. 6, comprise a lightening hole 1411 and/or other lightening structures to further reduce the weight of the flat plate structure 141 and/or to reduce stress between the power semiconductor devices 100. Moreover, the flat plate structure 141 may comprise an avoidance structure 1412 to provide space for other contacts, for example, the contacts providing electrical connections to the gates of the plurality of power semiconductor devices 100. The avoidance structure 1412 may also serve as the lightning hole 1411. The size and layout of the lightening holes 1411 and avoidance structures 1412 may be determined based on the distribution of the power semiconductor devices 100 and/or the configuration of the power semiconductor module 1.

Moreover, the flat plate structure 141 may have a vertical extension, namely, a height or thickness between 0.5 mm and 10 mm; preferably, between 0.5 mm and 3 mm; for example, 2 mm, 4 mm, 5 mm, or 7 mm. The thickness of the flat plate structure 141 may be determined based on the current distribution and heat distribution requirements of the power semiconductor module 1, especially for the SCFM mode. In some implementations, the flat plate structure 141 may be an integral metal plate or a stack of metal sheets, such as thin metal sheets with a thickness between 0.1 mm and 1.5 mm. The horizontal extension, namely, the width and the length of the flat plate structure 141 may be defined according to the dimension of the base plate, the distribution of the power semiconductor devices 100, and/or the size of the power semiconductor module 1. The flat plate structure 141 may not extend beyond an outer circumference of the base plate.

The flat plate structure 141 and the multiple protruding contact portions 142 may be made of a material with high electrical and thermal conductivities. For example, the material may comprise copper, copper alloys, aluminium, aluminium alloys, and/or other material with similar or better electrical and thermal conductivities. In some specific embodiments, the electrical conductivity of the material may be higher than 15 MS/m, preferably, higher than 25 MS/m. The thermal conductivity of the material may be higher than 120 W/m·K, preferably, higher than 200 W/m·K. In addition, the material may have a melting point higher than the maximum temperature of the power semiconductor in the event of short-circuit failures. The protruding contact portions 142 may be made of a material the same as or different from the flat plate structure.

In some configurations, the distribution plate 140 may be connected to the plurality of metal preforms 130 via dry contact, i.e., the distribution plate 140 may be pressed with its protruding contact portions against the plurality of metal preforms 130. The pressing force may be provided by the spring 150 and/or the pressure elements 160.

Alternatively, the multiple protruding contact portions 142 may be connected to the plurality of metal preforms 130 via soldering, sintering, adhesive bonding, or other applicable approaches. The plurality of metal preforms 130 may be a metal contact layer, a metal platelet, or a metal sheet formed or arranged on the top contact surfaces 101 of the power semiconductor devices 100.

The plurality of metal preforms 130 may be connected to the top contact surfaces 101 via soldering, sintering, adhesive bonding, or other applicable approaches. The plurality of metal preforms may be made of a material comprising at least one of the following: molybdenum, molybdenum alloys, aluminium, and aluminium alloys. It is noted that the material of the metal preforms is not limited to these examples. Other electrically conductive materials can also be used, provided the requirements of electrical conductivity and melting point of the power semiconductor module are fulfilled.

The metal preforms 130 may have a diameter or horizontal extension up to 20 mm, for example, 2 mm, 6 mm, 8 mm, 10 mm, 12 mm, 13 mm, or 16 mm. Preferably, the diameter or the horizontal extension of each metal preform may range from 8 mm to 15mm, more preferably, between 8 mm and 13 mm. Optionally, each metal preform may have a vertical extension, i.e., a height, between 0.2 mm and 3 mm; preferably, between 0.5 mm and 2 mm; for example, 0.8 mm, 1 mm, 1.2 mm, or 1.5 mm. It should be noted that the dimension of the metal preform is not limited to these examples and may be determined based on practical needs.

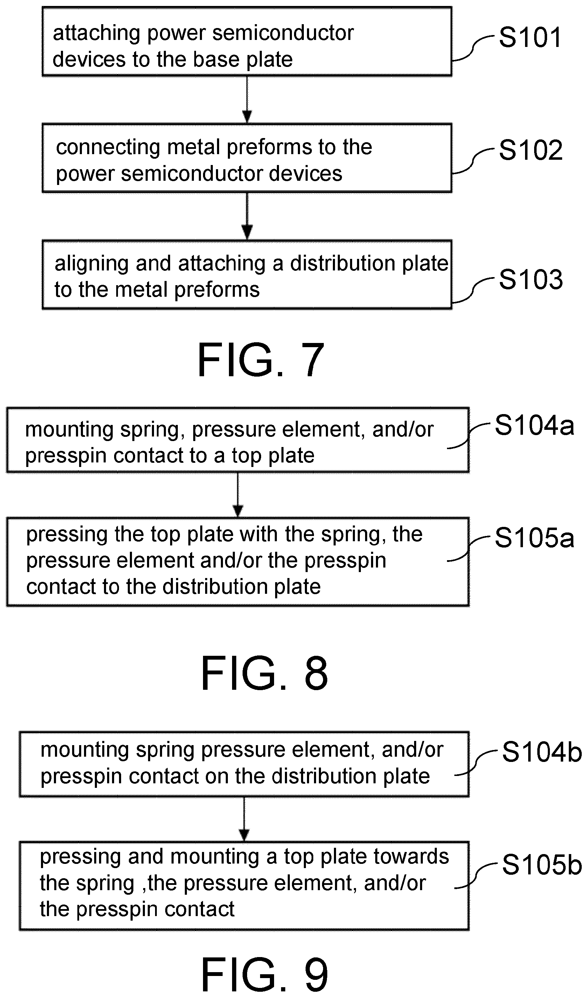

Fig. 7 shows a flow chart according to an implementation of a power semiconductor module assembling method. The method may be applied to assemble the power semiconductor modules 1 as described above. As shown in Fig. 7, the method comprises the following steps:
S101: attaching a plurality of power semiconductor devices 100 to an electrically conducting base plate 110,
S102: connecting a plurality of metal preforms 130 to top contact surfaces 101 of the plurality of power semiconductor devices 100, and
S103: aligning and attaching a distribution plate 140 to the plurality of metal preforms 130.

Specifically, the power semiconductor devices 100 can be attached to the base plate 110 via soldering or sintering, adhesive bonding, or other applicable approaches. The metal preforms 130 may also be connected to the top contact surfaces 101 via soldering, sintering, adhesive bonding, or other applicable approaches.

In step 103, the distribution plate 140 is aligned with the plurality of metal preforms 130 so that the multiple protruding contact portions 142 are aligned with the plurality of metal preforms 130.

When the distribution plate 140 comprises the flat plate structure 141 and the multiple protruding contact portions 142 that are formed as separate parts, the method may further comprise a step of mounting the multiple protruding contact portions 142 to the flat plate structure 141 before attaching the distribution plate 140 to the metal preforms 130.

Additionally, when the power semiconductor module 1 uses at least one spring 150, at least one pressure element 160, or at least one presspin contact 180. The at least one spring 150, at least one pressure element 160, and/or at least one presspin contact 180, and an electrically conducting top plate 120 will be mounted on a top surface of the distribution plate 140. As shown in Fig. 8, the method may further comprise the steps of:
S104a: mounting at least one spring 150, at least one pressure element 160, and/or at least one presspin contact 180 to a bottom surface 122 of an electrically conducting plate 120, and
S105a: pressing the top plate 120 with the at least one spring 150, at least one pressure element 160, and/or at least one presspin contact 180 towards the distribution plate 140.

Alternatively, as shown in Fig. 9, in some preferred implementations, the at least one spring 150, at least one pressure element 160, and/or the at least one presspin contact 180 may be first mounted to the top surface of the distribution plate 140. Then, the top plate 120 may be pressed towards the at least one spring 150, at least one pressure element 160, and/or at least one presspin contact 180. **In** this implementation, the method may further comprise the steps of:
S104b: mounting the at least one spring 150, at least one pressure element 160, and/or at least one presspin contact 180 to the distribution plate 140, and
S105b: pressing and mounting the top plate 120 with the bottom surface 122 toward the at least one spring 150, at least one pressure element 160, and/or at least one presspin contact 180.

**It** should be noted that, when the at least one presspin contact 180 comprises the presspin body, the spring and the current-carrying bracket. The method may comprise a step of mounting the spring and the current-carrying bracket to the presspin body before mounting the presspin contact 180 to the top plate 120 or the distribution plate 140.

While the invention has been illustrated and described in detail in the drawings and foregoing description, such illustrations and description are to be considered illustrative or exemplary and not restrictive; the invention is not limited to the disclosed implementations. Other variations to be disclosed implementations can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting scope.

### Reference signs list

- 1: power semiconductor module
- 100: power semiconductor device
- 101: top contact surface
- 110: base plate
- 120: top plate
- 122: bottom surface
- 130: metal preform
- 140: distribution plate
- 141: flat plate structure
- 1411: lightening hole
- 1412: avoidance structure
- 142: protruding contact portion
- 1422: bottom contact surface
- 150: spring
- 160: pressure element
- 170: current-carrying bracket
- 180: presspin contact

## Claims

1. A power semiconductor module (1) comprising:
an electrically conducting base plate (110),
a plurality of power semiconductor devices (100) arranged on the base plate (110) with top contact surfaces (101) facing away from the base plate (110),
a plurality of metal preforms (130) arranged on the top contact surfaces (101), and
a distribution plate (140) electrically connecting the top contact surfaces (101) in parallel via the plurality of metal preforms (130),
wherein the distribution plate (140) comprises a flat plate structure (141) and multiple protruding contact portions (142) extending toward and abutting the plurality of metal preforms (130).

2. The power semiconductor module (1) according to the previous claim, further comprising,
an electrically conducting top plate (120) arranged in parallel to the base plate (110) with a bottom surface (122) facing the distribution plate (140), and
at least one spring (150), at least one pressure element (160), and/or at least one presspin contact (180) arranged between the bottom surface (122) and the distribution plate (140).

3. The power semiconductor module (1) according to the previous claim, wherein
the at least one spring (150), the at least one pressure element (160), and/or the presspin contact (180) is electrically conductive.

4. The power semiconductor module (1) according to any one of the two previous claims, comprising the at least one spring (150) and
the at least one spring (150) comprises a spiral spring, a spring consisting of multiple disk-shaped elements, a volute spring, or a wave spring.

5. The power semiconductor module (1) according to any one of the three previous claims, comprising the at least one spring (150) and
at least one current-carrying bracket (170) surrounding and/or located beside the at least one spring (150).

6. The power semiconductor module (1) according to any one of the previous claims 1 to 3, comprising the at least one pressure element (160) and
the at least one pressure element (160) comprises at least one of: skived fins, a copper foam, a honeycomb structure, and a cushion element.

7. The power semiconductor module (1) according to any one of the previous claims, wherein the flat plate structure (141) and the multiple protruding contact portions (142) are formed as an integral piece or as separate parts.

8. The power semiconductor module (1) according to any one of the previous claims, wherein
the multiple protruding contact portions (142) have flat bottom contact surfaces (1422) abutting the plurality of metal preforms (130).

9. The power semiconductor module (1) according to the previous claim, wherein
the multiple protruding contact portions (142) have a round, oval, square, or rectangular cross-sectional shape.

10. The power semiconductor module (1) according to any one of the previous claims, wherein
the flat plate structure (141) and/or the multiple protruding contact portions (142) are made of a material comprising: copper, copper alloys, aluminium, and/or aluminium alloys.

11. The power semiconductor module (1) according to any one of the previous claims, wherein
the plurality of metal preforms (130) are connected to the top contact surfaces (101) via soldering, sintering and/or adhesive bonding.

12. The power semiconductor module (1) according to any one of the previous claims, wherein
the plurality of metal preforms (130) are made of a material comprising: molybdenum, molybdenum alloys, aluminium, or aluminium alloys.

13. The power semiconductor module (1) according to any one of the previous claims, wherein
the multiple protruding contact portions (142) are mechanically connected to the plurality of metal preforms (130) by pressing, or
the multiple protruding contact portions (142) are connected to the plurality of metal preforms (130) via soldering, sintering and/or adhesive bonding.

14. A method for assembling the power semiconductor module (1) according to any one of the previous claims, comprising the steps of:
attaching (S101) a plurality of power semiconductor devices (100) to an electrically conducting base plate (110),
connecting (S102) a plurality of metal preforms (130) to top contact surfaces of the plurality of power semiconductor devices (100), and
aligning and attaching (S103) a distribution plate (140) to the plurality of metal preforms (130).

15. The method according to the previous claim, comprising the steps of:
mounting (S104a) at least one spring (150), at least one pressure element (160) and/or at least one presspin contact (180) to a bottom surface (122) of an electrically conducting top plate (120), and
pressing (S105a) the top plate (120) with the at least one spring (150), at least one pressure element (160), and/or at least one presspin contact (180) towards the distribution plate (140), or
mounting (S104b) the at least one spring (150), at least one pressure element (160), and/or at least one presspin contact (180) to the distribution plate (140), and pressing (S105b) and mounting the top plate (120) with the bottom surface (122) toward the at least one spring (150), at least one pressure element (160), and/or at least one presspin contact (180).
